# EUROPÄISCHE PATENTSCHRIFT

(11) **EP 0 777 323 B1**
(45) Veröffentlichungstag und Bekanntmachung des Hinweises auf die Patenterteilung: **16.10.2002**
(21) Anmeldenummer: 96118577.4
(22) Anmeldetag: 20.11.1996
(51) Int. Cl.: H03F 3/21, H03F 1/02, H03F 3/30

(54) **Leistungsverstärker für eine induktive Last**
Power amplifier for an inductive load
Amplificateur de puissance pour une charge inductive

(30) Priorität: 29.11.1995 DE 19544368
(43) Veröffentlichungstag der Anmeldung: 04.06.1997
(73) Patentinhaber: DEUTSCHE THOMSON-BRANDT GMBH, 78048 Villingen-Schwenningen (DE)
(72) Erfinder: Gleim, Günter, 78052 Villingen-Schwenningen (DE)

(56) Entgegenhaltungen:
- EP-A- 0 196 703
- FR-A- 2 179 793
- US-A- 3 858 119

## Beschreibung

Die Erfindung geht aus von einem Leistungsverstärker gemäß dem Oberbegriff des Anspruchs 1. Ein derartiger Leistungsverstärker dient z.B. zur Erzeugung von Korrekturströmen, die in einer Fernsehprojektionsanlage den Konvergenz-Korrekturspulen zugeführt werden. Ein derartiger Korrekturstrom hat einen analogen Verlauf, z.B. sägezahnförmig, parabelförmig, cosinusförmig oder dgl., und ist in der Regel von Zeile zu Zeile unterschiedlich.

Derartige Korrekturströme haben insbesondere jeweils zu Beginn einer Fernsehzeile oftmals starke Stromänderungen, wobei z.B. der vorher sägezahnförmig angestiegene Strom zu Beginn einer Zeile in einer relativ kurzen Zeit wieder auf null abfällt. Eine derart starke Stromänderung bedingt an der induktiven Last zwangsläufig eine starke Spannungsänderung. Derartige Spannungsänderungen, die auch die Form von Impulsen oder Spannungspitzen haben können, bewirken in der Regel eine nennenswerte Verlustleistung an dem Verstärker.

Eine Möglichkeit, die Verlustleistung zu verringern, besteht gemäß FR 2 179 793 A darin, mehrere Betriebsspannungen zu verwenden und Mittel zum Wirksam- und Unwirksamschalten derselben vorzusehen, so dass eine der Änderungsgeschwindigkeit des Stromes angepaßte Betriebsspannung an die Last geschaltet wird. Durch das Anschalten einer unterschiedlichen Betriebsspannung im Falle einer starken Stromänderung kann eine Verminderung der durch Induktionseffekte verursachten Verlustleistung erzielt werden, aufgrund der Verbindung zur Betriebsspannungsquelle treten jedoch immer noch beträchtliche Verluste auf.

Aus der US 3 488 551 A ist eine weitere Verstärkerschaltung für eine magnetische Ablenkeinrichtung bekannt. Bei dieser Schaltung kommt bei langsam veränderlichen Strömen eine erste Betriebsspannungsquelle mit einer ersten niedrigen Betriebsspannung zum Einsatz. Nur bei schnell veränderlichen Strömen wird eine zweite Betriebsspannung mit einer höheren Betriebsspannung eingeschaltet. Der Wechsel zwischen den Spannungsquellen erfolgt, um die Verlustleistung zu minimieren.

Der Erfindung liegt die Aufgabe zugrunde, einen Verstärker auf einfache Weise so auszubilden, daß die an dem Verstärker auftretende Verlustleistung weiter verringert wird. Diese Aufgabe wird durch die im Anspruch 1 angegebene Erfindung gelöst. Vorteilhafte Weiterbildungen der Erfindung sind in den Unteransprüchen angegeben.

Die Erfindung besteht somit darin, daß in einem Verstärker gemäß dem Oberbegriff des Anspruchs 1 das Netzwerk beim überschreiten einer Schwellen Spannung an der Spule die zweite Betriebsspannung an die Basis des ersten Transistors zuführt, so daß der erste Transistor sperrt, und so daß die Amplitude der Ausgangsspannung an der Last größer werden kann als die erste Betriebsspannung.

Die Einsparung an Verlustleistung wird insbesondere durch zwei Schaltungs- bzw. Bemessungsmerkmale erreicht.

Ein wesentlicher Vorteil der Erfindung besteht darin, daß die Ausgangsspannung an der Last wesentlich höhere Werte annehmen kann als die die Endstufe speisende erste Betriebsspannung. Das erscheint ohne weiteres zunächst nicht möglich, weil dann die Ausgangstransistoren leitend werden und die Ausgangsspannung auf die erste Betriebsspannung klemmen, also gewissermaßen abkappen. Die vorteilhafte Wirkung, daß die Ausgangsspannung den Wert der ersten Betriebsspannung übersteigen kann, wird dadurch erreicht, daß an das Netzwerk im Basiskreis des ersten Transistors eine zweite Betriebsspannung angelegt ist, die größer ist als die erste Betriebsspannung. Diese zweite Betriebsspannung sorgt dann dafür, daß der erste Endstufentransistor an der Basis eine Spannung bekommt, die etwa gleich ist der Maximalamplitude der Ausgangsspannung an der Last. Dadurch wird verhindert, daß die Ausgangsspannung an der Last auf die erste Betriebsspannung geklemmt und bei dieser Spannung abgekappt wird. Es wird dann zwar eine zweite Betriebsspannung benötigt, die größer ist als die erste Betriebsspannung. Diese zweite Betriebsspannung gelangt aber nur auf das leistungsarme Netzwerk im Basiskreis des Endstufentransistors und bewirkt nur eine geringe Verlustleistung. Die erste Betriebsspannung, die die eigentliche Leistung für die Endstufe liefert, behält dabei ihren niedrigeren Wert nennenswert unterhalb der Maximalamplitude der Ausgangsspannung.

Vorzugsweise ist der Mittelpunkt der Reihenschaltung der beiden Endstufentransistoren über eine für die durch Stromänderungen bedingte Spannungsabschnitte in Durchlaßrichtung gepolte Diode mit einem Bezugspotential verbunden, das nennenswert kleiner ist als die erste Betriebsspannung. Vorzugsweise ist die Diode mit Erde verbunden. Dadurch wird folgende vorteilhafte Wirkung erreicht. Bei einer starken Stromänderung in der induktiven Last entsteht an der Last unvermeidbar ein Spannungsabschnitt mit einer starken Änderung. Bei einem Stromabfall hat dieser Spannungsabschnitt negative Polarität. Während dieses Spannungsabschnittes fließt der Strom zunächst mit gleicher Polarität wie vor Beginn des Stromabfalls weiter. Damit dieser Strom fließen kann, muß eine den Strom treibende Spannung vorhanden sein. Bei bekannten Schaltungen bleibt während dieser Zeit der Verstärker an die Betriebsspannung angeschlossen, wodurch eine nennenswerte Verlustleistung entsteht. Die Erfindung beruht nun auf der Erkenntnis, daß für den genannten Zeitabschnitt während der starken Stromänderung in der induktiven Last allein die Induktionsspannung an der induktiven Last als treibende Spannung ausreicht. Das bedeutet, daß während dieser Zeit der Verstärker von der Betriebsspannung völlig getrennt ist und somit dem Netzteil keine Leistung entnommen wird. Dennoch behält der Strom in der induktiven Last seinen gewünschten Verlauf. Die Betriebsspannung während des negativen oder positiven Spannungsabschnittes aufgrund der Stromänderung braucht also nicht aus dem Netzteil zur Verfügung gestellt zu werden, sondern wird durch die Induktionsspannung an der indutkiven Last aufgrund der Stromänderung selbst gebildet.

Wenn die Diode nicht an Erde, sondern an eine dritte Betriebsspannung angeschlossen ist, die nennenswert kleiner ist als die erste Betriebsspannung, arbeitet der Verstärker bei kleiner Signalamplitude an der Last über die Diode mit der geringeren dritten Betriebsspannung und bei großer Signalamplitude über den ersten Transistor mit der ersten Betriebsspannung.

Die Erfindung wird im folgenden anhand der Zeichnung an einem Beispiel mit konkreten Spannungsangaben erläutert. Bei der Betrachtung der Spannungen ist jeweils die Basis/Emitter-Flußspannung der Transistoren von etwa 0,7 V vernachlässigt. In der Zeichnung zeigen:
- Fig. 1: ein Ausführungsbeispiel eines erfindungsgemäßen Verstärkers und
- Fig. 2: Kurven zur Erläuterung der Wirkungsweise des Verstärkers gemäß Fig. 1.

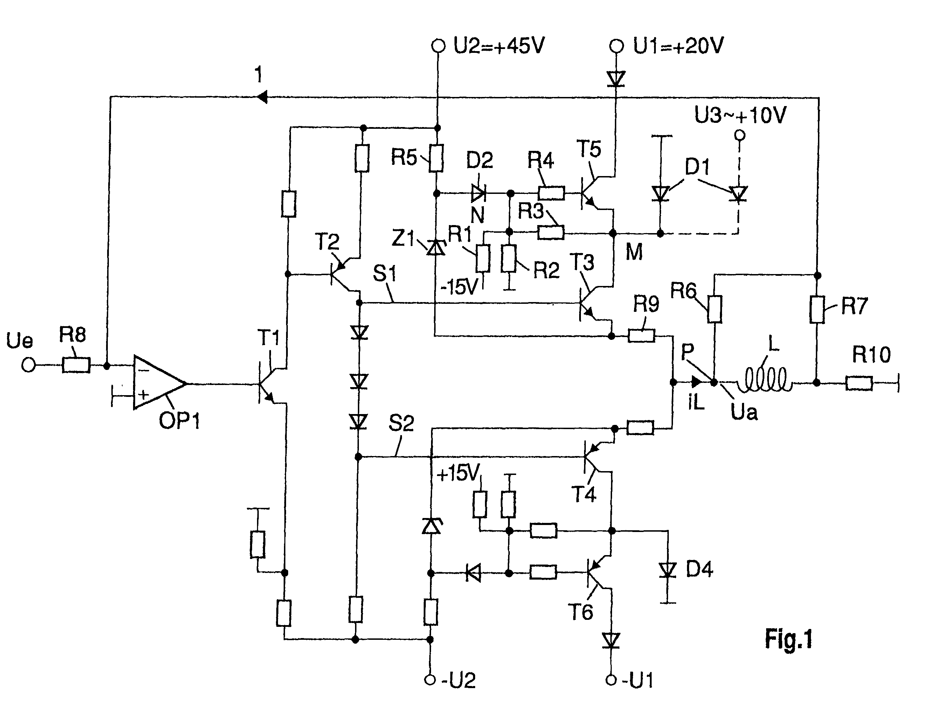

In Fig. 1 gelangt die Eingangsspannung Ue über den Widerstand R8 und über den Operationsverstärker OP1 an den Eingang der Treiberschaltung mit den Transistoren T1, T2. Vom Ausgang der Treiberschaltung T1, T2 gelangt die Spannung über die Leitung S1 auf die Basis des Endstufentransistors T3, der über den Transistor T5 an die erste Betriebsspannung U1 von +20 V angeschlossen ist. Eine zweite Betriebsspannung U2 von +45 V dient als Betriebsspannung für die Treiberstufe T1, T2 und speist außerdem das Netzwerk N mit der Diode D2 und den Widerständen R1, R2, R3, R4 im Basiskreis des Transistors T5. Der Emitter des Transistors T3 ist über einen niederohmigen Schutzwiderstand R9 von etwa 1 Ohm an eine induktive Last in Form der Spule L angeschlossen, deren anderes Ende über den Strommeßwiderstand R10 geerdet ist. Der Emitter von T3 ist außerdem über die als Schwellwertelement dienende Zenerdiode Z1 an das Netzwerk N angeschlossen. Zwischen dem Ausgang und dem Eingang der Schaltung ist ein Rückkopplungsweg mit den Widerständen R6, R7 und der Leitung 1 vorgesehen. Dieser Teil der Schaltung wirkt für positive Ströme iL mit der dargestellten Richtung durch die Spule L. Der untere Teil der Schaltung mit den Transistoren T4, T6 ist komplementär und im Aufbau identisch mit dem oberen Teil. Sie arbeitet für Ströme iL mit entgegengesetzter Polarität und wird daher im folgenden nicht gesondert beschrieben.

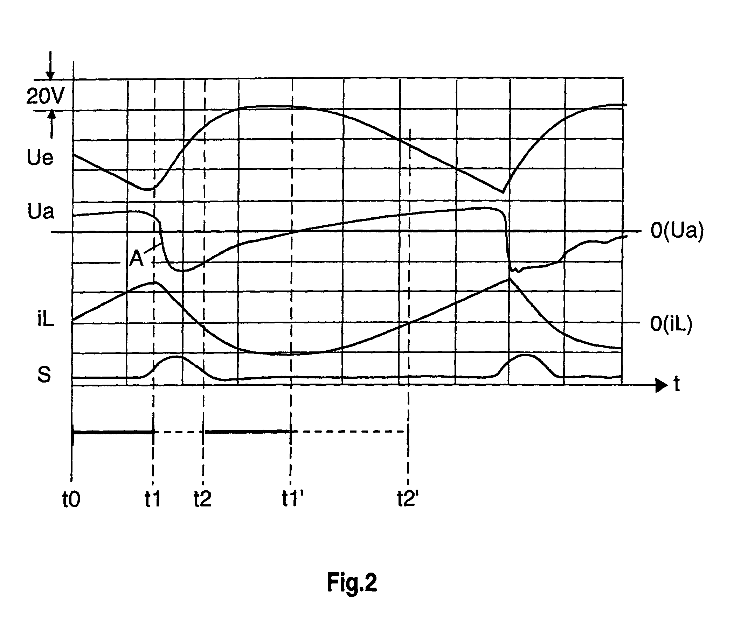

Die Wirkungsweise dieser Schaltung wird im folgenden anhand der Fig. 2 erläutert. Die obere Kurve in Fig. 2 zeigt die Eingangsspannung Ue. Von t0 - t1 bewirkt diese Eingangsspannung Ue einen etwa sägezahnförmig ansteigenden Strom iL durch die Spule L. Während dieser Zeit sind die Endstufentransitoren T5, T3 beide leitend. Der Strom zwischen t0 und t1 fließt somit von der Betriebsspannungsklemme für U1 über T5, T3, R9,L und R10. Zwischen t0 und t1 ist somit die Endstufe mit den Endstufentransistoren T5 und T3 an die Betriebsspannung U1 angeschlossen. Während dieser Zeit wird also dem Netz Leistung entnommen.

Im Zeitpunkt t1, der z.B. das Ende einer durch die Synchronimpulse S definierten Zeile darstellt, beginnt aufgrund des Verlaufes von Ue ein starker Abfall des Stromes iL. Dieser Stromabfall bedingt aufgrund der Induktivität der Spule L am Punkt P einen negativen Spannungsabschnitt A in der Ausgangsspannung Ua bis auf etwa -30 Volt. Durch die Rückkopplung über die Leitung 1 ist der Transistor T1 an der Basis negativ und daher ebenso der Kollektor des Transistors 2. Dadurch werden auch die Basis von T3 und der Emitter von T3 negativ. Der abfallende Strom iL von t1 - t2 fließt weiter über den leitenden Transistor T3. Der abfallende Strom iL kommt aber nicht mehr von der Betriebsspannung U1, sondern über die nunmehr durch den negativen Spannungsabschnitt A leitend gesteuerte, gegen Erde geschaltete Diode D1. Der Mittelpunkt M ist somit praktisch mit Erde verbunden. Der Transistor T5 ist dabei über die Zenerdiode Z1 und das Netzwerk N gesperrt. Die Betriebsspannung U1 von +20 Volt ist also von der Endstufe abgeschaltet, so daß während dieser Zeit dem Netz kein Strom und keine Leistung entnommen werden. Die Schaltung arbeitet also von t1 - t2 mit einer in ihr selbst erzeugten Betriebsspannung, nämlich mit der durch die Stromänderung von iL in der Spule L entstehenden Induktionsspannung.

Die Ausgangsspannung Ua an der Spule L kann den Wert der Betriebsspannung U1 von +20 Volt überschreiten und wird nicht durch den Transistor T5 auf U1 geklemmt oder abgekappt. Das wird dadurch erreicht, daß an die Basis von T5 die höhere zweite Betriebsspannung von U2 = +45 Volt angelegt ist, die eine Sperrung von T5 sicherstellt. Die Ausgangsspannung von Ua kann also Werte von etwa bis zu +45 Volt annehmen, obwohl die einzige, die Endstufe mit Energie versorgende Betriebsspannung U1 nur 20 Volt beträgt.

Im Zeitraum t2 - t1' wird wieder dem Netz Energie entnommen. Da jetzt der Strom iL negativ ist, fließt dieser Strom jedoch von der negativen Betriebsspannung -U1. Für den Zeitraum t1' - t2' gelten wieder die gleichen Vorteile wie für den Zeitraum t1 - t2. Das bedeutet, da auch in diesem Zeitraum die Betriebsspannung -U1 abgeschaltet ist, die Diode D4 leitend ist und dem Netzteil keine Energie entnommen wird. Der Zeitpunkt t2' entspricht dann wieder nach Ablauf der Periode dem Zeitraum t0. Die Zeiträume t1 - t2 und t1' - t2' stellen also die Zeiten dar, während der die beschriebenen Vorteile und die Verringerung der Verlustleistung erzielt werden.

Die Diode D1 muß nicht unbedingt mit Erde verbunden sein. Wie in Fig. 1 fakultativ gestrichelt dargestellt, kann die Diode D1 auch an eine Spannung U3 angeschlossen sein, die nennenswert geringer ist als U1, z.B. eine Spannung von +10 V. Dann arbeitet die Schaltung folgendermaßen: Solange die Spannung Ua im Bereich von 0 - 10 V liegt, fließt der Strom von der Klemme für U3 über die Diode D1 und den Transistor T3, während T5 durch entsprechende Bemessung des Netzwerkes N gesperrt ist. Wenn die Spannung Ua den Wert von +10 V überschreitet, wird über die Zenerdiode Z1 und das Netzwerk N der Transistor T5 eingeschaltet und die Diode D1 zwischen dem Punkt M und + 10 V gesperrt. Dann arbeitet die Endstufe mit der Betriebsspannung U1.

## Patentansprüche

1. Leistungsverstärker für eine induktive Last (L), wobei eine erste Betriebsspannung (U1) über die Reihenschaltung eines ersten (T5) und eines zweiten (T3) Endstufentransistors an eine die Last darstellende Spule (L) angelegt ist,und an der Spule (L) durch Stromänderungen bedingte Spannungsabschnitte (A) auftreten, mit einem Netzwerk (N), das an die Basis des ersten Transistors (T5) an eine zweite Betriebsspannung (U2) angeschlossen ist, die größer ist als die erste Betriebsspannung (U1), **dadurch gekennzeichnet, daß** das Netzwerk beim Überschreiten einer Schwellenspannung an der Spule (L) die zweite Betriebsspannung (U2) an die Basis des ersten Transistors (T5) zuführt, so daß der erste Transistor sperrt, und so daß die Amplitude der Ausgangsspannung (Ua) an der Spule (L) größer werden kann als die erste Betriebsspannung (U1).

2. Verstärker nach Anspruch 1, **dadurch gekennzeichnet, daß** der Mittelpunkt (M) der Reihenschaltung (T5, T3) über eine für die Spannungsabschnitte (A) in Durchlaßrichtung gepolte Diode (D1) mit einer dritten Betriebsspannung (U3) und/oder einem Bezugspotential verbunden ist, das nennenswert kleiner ist als die erste Betriebsspannung (U1).

3. Verstärker nach Anspruch 2, **dadurch gekennzeichnet, daß** die Diode (D1) mit Erde verbunden ist.

4. Verstärker nach Anspruch 2, **dadurch gekennzeichnet, daß** die dritte Betriebsspannung (U3) so bemessen ist, daß der Verstärker bei kleiner Signalamplitude an der Spule (L) über die Diode (D1) mit der dritten Betriebsspannung (U3) und bei großer Signalamplitude über den ersten Transistor (T5) an die erste Betriebsspannung (U1) angeschlossen ist.

5. Verstärker nach Anspruch 1, **dadurch gekennzeichnet, daß** das Netzwerk (N) an der Basis des ersten Transistors über ein Schwellwertelement (Z1) mit der Spule (L) verbunden ist.

6. Verstärker nach Anspruch 1, **dadurch gekennzeichnet, daß** die zweite Betriebsspannung (U2) zusätzlich als Betriebsspannung für eine dem Verstärker vorgeschaltete Treiberstufe (T1, T2) dient.

## Claims

1. Power amplifier for an inductive load (L), a first operating voltage (U1) being applied to a coil (L) constituting the load via the series circuit formed by a first (T5) and a second (T3) output stage transistor, and voltage sections (A) brought about by current changes occurring at the coil (L), including a network (N) at the base of the first transistor (T5) and connected to a second operating voltage (U2) which is greater than the first operating voltage (U1),
**characterized in that**
said network (N) applies the second operating voltage (U2) to the base of the first transistor (T5) if a threshold voltage at the coil is exceeded so that the first transistor is cut off and in such a way that the amplitude of the output voltage (Ua) at the coil (L) can become greater than the first operating voltage (U1)

2. Amplifier according to claim 1, **characterized in that** the centre point (M) of the series circuit (T5, T3) is connected to a third operating voltage (U3) and/or to a reference potential, which is appreciably smaller than the first operating voltage (U1), via a diode (D1) which is forward biased for the voltage sections (A).

3. Amplifier according to claim 2, **characterized in that** the diode (D1) is connected to earth.

4. Amplifier according to claim 2, **characterized in that** the third operating voltage (U3) is rated in such a way that the amplifier is connected via the diode (D1) to the third operating voltage (U3) in the event of a small signal amplitude at the coil (L), and is connected via the first transistor (T5) to the first operating voltage (U1) in the event of a large signal amplitude.

5. Amplifier according to claim 1, **characterized in that** the network (N) at the base of the first transistor is connected to the coil (L) via a threshold value element (Z1).

6. Amplifier according to claim 1, **characterized in that** the second operating voltage (U2) additionally serves as operating voltage for a driver stage (T1, T2) connected upstream of the amplifier.

## Revendications

1. Amplificateur de puissance pour une charge inductive (L), dans lequel une première tension de service (U1) est affectée via le montage en série d'un premier (T5) et d'un second (T3) transistors de l'étage de sortie à une bobine (L) représentant la charge, et des portions de tension conditionnées par les variations de tension apparaissent à la bobine (L), avec un réseau (N) connecté, à la base du premier transistor (T5), à une deuxième tension de service (U2), qui est supérieure à la première tension de service (U1), **caractérisé en ce que** le réseau, en cas de dépassement d'une tension seuil à la bobine (L), affecte la deuxième tension de service (U2) à la base du premier transistor (T5), de façon à bloquer le premier transistor, et de façon à ce que l'amplitude de la tension de sortie (Ua) à la bobine (L) puisse être supérieure à la première tension de service (U1).

2. Amplificateur selon la revendication 1, **caractérisé en ce que** le point central (M) du montage en série (T5, T3) est relié, via une diode (D1) polarisée dans le sens du courant pour les portions de tension (A), à une troisième tension de service (U3) et/ou un potentiel de référence, qui est notablement inférieur à la première tension de service (U1).

3. Amplificateur selon la revendication 2, **caractérisé en ce que** la diode (D1) est reliée à la terre.

4. Amplificateur selon la revendication 2, **caractérisé en ce que** la troisième tension de service (U3) est dimensionnée de façon à ce que l'amplificateur, en cas de faible amplitude du signal à la bobine (L), soit connecté via la diode (D1) à la troisième tension de service (U3), et, en cas d'amplitude du signal plus grande, soit connecté via le premier transistor (T5) à la première tension de service (U1).

5. Amplificateur selon la revendication 1, **caractérisé en ce que** le réseau (N) est relié à la base du premier transistor via un élément à seuil (Z1) avec la bobine (L).

6. Amplificateur selon la revendication 1, **caractérisé en ce que** la deuxième tension de service (U2) sert en outre de tension de service pour un étage d'excitation (T1,T2) monté en amont de l'amplificateur.
